# FASCICULE DE BREVET EUROPEEN

(11) **EP 3 903 417 B1**
(45) Date de publication et mention de la délivrance du brevet: **22.02.2023**
(21) Numéro de dépôt: 19832413.9
(22) Date de dépôt: 27.12.2019
(51) Int. Cl.: H03H 9/02, H03H 9/64

(54) **DISPOSITIF À ONDE ACOUSTIQUE DE SURFACE AMÉLIORÉ**
VERBESSERTE OBERFLÄCHENSCHALLWELLENVORRICHTUNG
IMPROVED SURFACE ACOUSTIC WAVE DEVICE

(30) Priorité: 28.12.2018 FR 1874201
(43) Date de publication de la demande: 03.11.2021
(73) Titulaire: THALES, 92400 Courbevoie (FR); Centre National de la Recherche Scientifique, 75016 Paris (FR); FREC'N'SYS, 25000 Besancon (FR); Yncrea Hauts-de-France Etablissement Isen Lille, 59046 Lille (FR); Université de Lille, 59800 Lille (FR); Ecole Centrale De Lille, 59650 Villeneuve d'Ascq (FR); Université Polytechnique Hauts-de-France, 59313 Valenciennes (FR)
(72) Inventeur: PHAM COLOMBAN, Thi Mai, 91767 Palaiseau (FR); PRÉVOT, Claude, 91767 Palaiseau (FR); MARTINS, Paolo, 91767 Palaiseau (FR); HLADKY- HENNION, Anne-Christine, 59700 Marcq en Baroeul (FR); DUBUS, Bertrand, 59790 Ronchin (FR); SAGNARD, Marianne, 25000 Besancon (FR); LAROCHE, Thierry, 25000 Besancon (FR); BALLANDRAS, Sylvain, 25000 Besancon (FR); CROENNE, Charles, 59000 Lille (FR)
(74) Mandataire: Atout PI Laplace
(86) Numéro de dépôt international: PCT/EP2019/087103
(87) Numéro de publication internationale: WO 2020/136262

(56) Documents cités:
- EP-A1- 1 420 514
- EP-A2- 0 415 063
- JP-A- S52 105 752
- US-A1- 2009 224 854
- US-A1- 2016 134 257
- US-A1- 2018 026 605
- US-B1- 6 291 924
- YAMANOUCHI K ET AL: "New Types of SAW Reflector and Resonator with Alternative (Positive and Negative) Reflection Coefficients", IEEE 1984 ULTRASONICS SYMPOSIUM, IEEE, 14 novembre 1984 (1984-11-14), pages 224-228, XP032284302, DOI: 10.1109/ULTSYM.1984.198294
- REINDL L ET AL: "Programmable reflectors for SAW-ID-tags", ULTRASONICS SYMPOSIUM, 1994. PROCEEDINGS., 1994 IEEE CANNES, FRANCE 1-4 NOV. 1994, NEW YORK, NY, USA,IEEE, US, 31 octobre 1993 (1993-10-31), page 125, XP033405774, DOI: 10.1109/ULTSYM.1993.339692 ISBN: 978-0-7803-2012-3

## Description

### DOMAINE DE L'INVENTION

L'invention concerne le domaine des composants pour télécommunications à base d'ondes acoustiques de surface, dénommés SAW pour « Surface Acoustic Wave » en anglais. Plus particulièrement l'invention concerne des filtres fréquentiels ou des sources, et selon un mode de réalisation de l'invention des filtres et des sources agiles en fréquence.

### ETAT DE LA TECHNIQUE

Dans le cadre des télécommunications un grand nombre de bandes de Radio-Fréquences (RF) sont utilisées afin de transmettre ou de recevoir l'information. Chaque bande définit un canal pour lequel des fonctions de filtrage sont nécessaires afin de restituer l'information. Il y a donc autant de filtres que de bandes RF et pour passer de l'une à l'autre des commutateurs ou « switchs » sont également nécessaires.

Le domaine des sources comprend également une quantité importante de bandes de fréquences adressées. Encore une fois, il est nécessaire d'associer à chaque bande une source de fréquences idoine.

Les dispositifs SAW sont largement utilisés comme composants de filtrage dans le domaine des télécommunications ainsi que dans celui des sources pour réaliser des oscillateurs. Ils ont une réponse spectrale (ou en fréquences) définie dès leur conception et leur fabrication à partir de leur géométrie et des matériaux utilisés. Lorsque plusieurs bandes de fréquences sont adressées sur un seul et même dispositif, chaque bande est traitée par un composant SAW spécifique, ce qui implique une augmentation du volume occupé et du coût.

Il n'y a pas actuellement d'agilité en fréquence. L'agilité en fréquence des dispositifs de filtrage ou des oscillateurs Radio-Fréquence (RF) définit la capacité de ces dispositifs à voir leur fréquence de fonctionnement évoluer en fonction de paramètres externes ou internes aux dispositifs. Ce phénomène est dit contrôlé si les autres figures de mérite du dispositif sont préservées lorsque les paramètres considérés évoluent.

Les SAW (Surface Acoustic Waves) sont des dispositifs largement utilisés dans le domaine des composants pour les télécommunications.

D'une manière générale, le fonctionnement de ces dispositifs repose sur la conversion de l'énergie électrique en au moins une onde élastique via un transducteur comprenant typiquement deux peignes d'électrodes inter digitées déposés à la surface d'un matériau piézoélectrique ou non. L'effet inverse est également considéré. L'efficacité de cette conversion est directement liée au coefficient de couplage électromécanique intrinsèque du matériau ainsi qu'à la configuration géométrique des électrodes du transducteur et à la nature du métal les constituant.

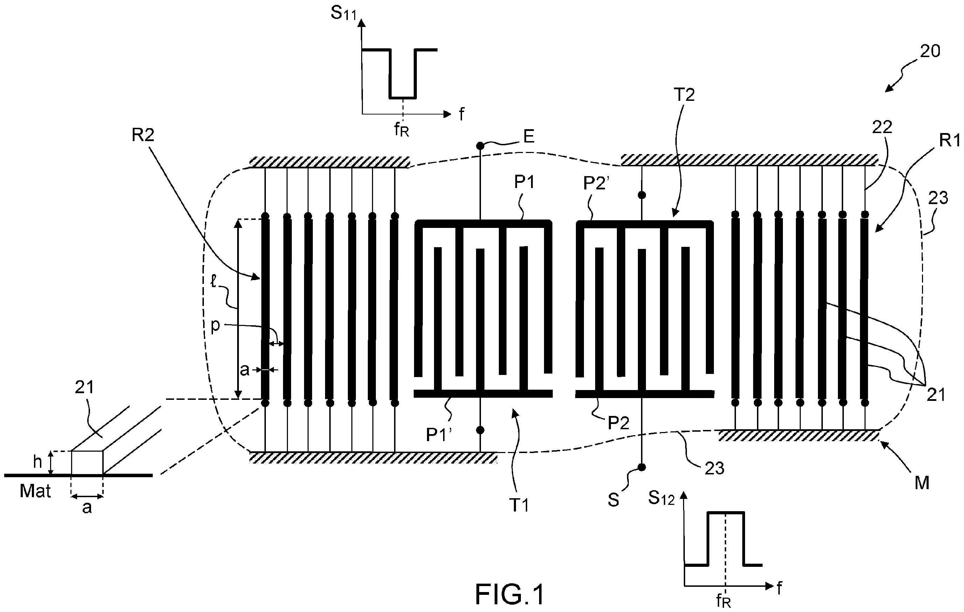

Un dispositif à ondes élastiques de surface 20 est illustré sur la figure 1. Il comprend tout d'abord un ou plusieurs transducteurs (deux transducteurs T1 et T2 sur la figure 1) permettant de générer le phénomène vibratoire mécanique également dénommé onde acoustique.

Un SAW dit simple port comprend un transducteur unique, un peigne d'électrodes étant connecté à l'entrée électrique et l'autre peigne étant connecté à la masse du dispositif. Un SAW dit double port tel qu'illustré figure 1 comprend deux transducteurs T1 et T2, chacun comprenant deux peignes P1, P1' et P2, P2'. Le transducteur T1 opère par exemple comme entrée (excitation) avec son peigne P1 connecté à l'entrée électrique E et T2 opère comme sortie, avec son peigne P2' connecté à la sortie électrique S (récupération). Les peignes P1' et P2' sont connectés à la masse.

Dans une configuration ligne à retard l'onde acoustique créée se propage librement à la surface du matériau. Dans la configuration résonateur qui nous intéresse ici illustrée figure 1 l'onde acoustique est piégée dans une cavité par le biais de réflecteurs acoustiques, que nous dénommerons par la suite miroirs, placés de part et d'autre du ou des transducteurs.

Les transducteurs peuvent être collés ou séparés par un gap (espace de propagation libre de l'onde) ou un réseau d'électrodes (appelé coupleur).

Les réflecteurs acoustiques sont des miroirs de Bragg disposés de part et d'autre de cette zone de transduction. Ils sont formés de réseaux périodiques d'électrodes R1 et R2 déposées sur la surface du même substrat Mat, et assurent un fort coefficient de réflexion pour les ondes acoustiques de surface dans une certaine gamme de fréquences, appelée bande interdite.

Typiquement les électrodes des miroirs présentent la forme de lignes 21 parallèles entre elles et réparties périodiquement selon une période p. Le barreau formé par chaque électrode 21 est caractérisé par des paramètres géométriques: une longueur I, une hauteur h et une largeur a.

Les paramètres géométriques des électrodes des miroirs sont identiques ou différents de ceux des électrodes des transducteurs.

Les électrodes des miroirs sont classiquement connectées à la masse du système, les connexions étant illustrées par les traits 22 sur la figure 1.

Préférentiellement les électrodes sont connectées à la masse aux deux extrémités. Ce choix d'une connexion directe à la masse électrique permet l'obtention d'un composant de réalisation simple, minimisant les effets électriques parasites au niveau des électrodes et maximisant l'efficacité générale des miroirs.

Les différents plans de masse M sont bien entendu reliés entre eux, cette liaison étant symbolisée par les pointillés 23.

Pour le cas d'un filtre, les miroirs forment la cavité résonante à l'intérieur de laquelle un ou plusieurs transducteurs électroacoustiques génèrent et reçoivent les ondes élastiques destinées à la réalisation de la fonction spectrale du filtre. On utilise classiquement le coefficient S11 pour caractériser la réflexion du filtre (PRéf léchie/P Incident) et le coefficient S12 pour caractériser la transmission du filtre (PTransmise/Plncident). Ces coefficients sont calculés directement à partir des signaux électriques radiofréquences incidents, réfléchis et transmis au niveau des transducteurs. La figure 1 illustre les coefficients S11 et S12 caractéristiques d'un filtre passe bande. La fréquence de fonctionnement f_{R} d'un tel dispositif, également dénommée fréquence nominale du filtre, dépend de nombreux paramètres dont le matériau utilisé pour le substrat, les paramètres géométriques définissant les électrodes du ou des transducteurs ainsi que les électrodes des miroirs, et l'interaction entre ces divers éléments.

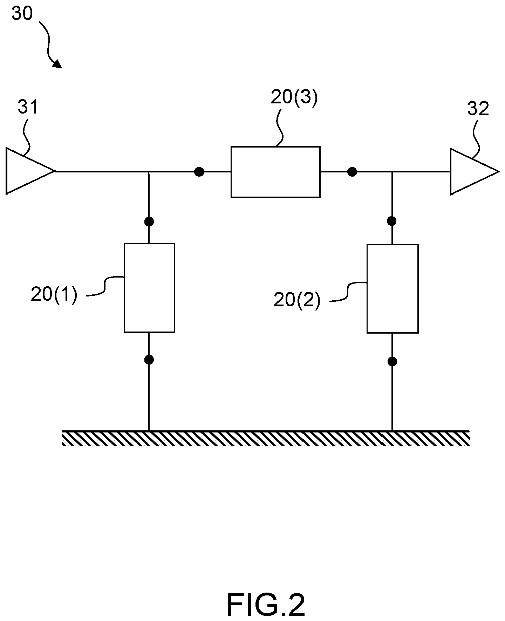

Par ailleurs pour générer des filtres aux caractéristiques spécifiques il est classique de réaliser des agencements de SAW à partir de différents SAW élémentaires disposés en parallèle et/ou en série. La figure 2 illustre un exemple d'agencement d'un filtre en échelle 30 ou « ladder » en anglais basé sur une « cascade » de résonateurs SAW élémentaires simple port 20(1), 20(2) et 20(3) réalisant le filtrage d'un signal injecté via l'entrée 31 et récupéré à la sortie 32.

Les résonateurs SAW selon l'état de la technique ont une réponse définie dès leur conception et leur fabrication. Ainsi si l'on souhaite réaliser des filtres/sources SAW avec des fréquences nominales différentes il convient de designer des filtres présentant des paramètres géométriques différents. En outre il n'est pas possible de réaliser des filtres ou des oscillateurs agiles en fréquence.

Des exemples de dispositifs à ondes acoustiques de surface de l'art antérieur sont décrits dans les documents suivants : US 2009/224854, EP1420514, JP S52 105752, US 2018/026605, XP32284302, XP33405774.

L'invention vise à surmonter au moins l'un des inconvénients précités en proposant un dispositif à onde acoustique de surface présentant un comportement fréquentiel fonction de conditions aux limites que l'on peut modifier sans changement des paramètres géométriques du composant, et agile en fréquence.

### DESCRIPTION DE L'INVENTION

La présente invention a pour objet un dispositif à onde acoustique de surface agile en fréquence comprenant :
- au moins un transducteur,
- deux réflecteurs acoustiques disposés de part et d'autre de l'au moins un transducteur de manière à former une cavité, chaque réflecteur acoustique comprenant un réseau d'électrodes en forme de lignes parallèles entre elles, chaque réseau comprenant un sous ensemble d'électrodes connectées à un potentiel de référence dénommé masse définissant un premier type de connexion, et un sous ensemble d'électrodes qui ne sont connectées à aucun potentiel, c'est-à-dire qui présentent une connexion flottante définissant un deuxième type de connexion,
- au moins un circuit de commutation (CCOM) configuré pour modifier la répartition des connexions d'au moins une partie des électrodes de chaque réseau entre les différents types de connexion.

Préférentiellement le dispositif à onde acoustique de surface selon l'invention comprend un ou deux transducteurs.

Selon une première variante chaque électrode ne peut présenter que le premier ou le deuxième type de connexion.

Selon une deuxième variante le dispositif à onde acoustique de surface selon l'invention comprend en outre, pour au moins un sous ensemble des électrodes de chaque réflecteur acoustique, une impédance entre chacune desdites électrodes dudit sous ensemble et la masse, définissant un troisième type de connexion.

Préférentiellement la répartition des connexions des électrodes entre les différents types est symétrique par rapport à l'au moins un transducteur. Selon un mode de réalisation des connexions des électrodes sont réalisées individuellement pour chaque réseau.

Selon un autre mode de réalisation, pour chaque réseau, des électrodes sont reliées entre elles définissant des paquets, la connexion s'effectuant par paquet.

Selon un mode de réalisation, pour chaque réseau, un sous ensemble d'électrodes voisines disposées à une extrémité du réseau est connecté à la masse.

Selon un mode de réalisation, qui peut être combiné au mode précédent, pour chaque réseau, un sous ensemble d'électrodes voisines disposées à une extrémité du réseau présente une connexion flottante.

Selon un mode de réalisation qui peut être combiné aux modes précédents, pour chaque réseau, des électrodes forment un motif périodique, un motif comprenant au moins une électrode connectée à la masse et une électrode flottante.

Selon un mode de réalisation, pour chaque réseau, des électrodes sont reliées individuellement au circuit de commutation de sorte que la modification de connexion desdites électrodes s'opère individuellement. Selon un autre mode de réalisation, pour chaque réseau, des électrodes sont reliées entre elles pour former des paquets, chaque paquet étant relié au circuit de commutation de sorte que la modification de connexion des électrodes s'opère par paquet.

Selon un autre aspect l'invention concerne un filtre en fréquence comprenant un dispositif à onde acoustique de surface selon l'invention. Préférentiellement le filtre en fréquence comprend une pluralité de dispositifs à onde acoustique de surface selon l'invention agencés en série et/ou en parallèle.

Selon un autre aspect l'invention concerne un oscillateur comprenant un circuit inverseur et un dispositif à onde acoustique de surface selon l'invention agencé en parallèle dudit circuit inverseur, le dispositif à onde acoustique de surface comprenant deux transducteurs.

La description suivante présente plusieurs exemples de réalisation du dispositif de l'invention : ces exemples sont non limitatifs de la portée de l'invention. Ces exemples de réalisation présentent à la fois les caractéristiques essentielles de l'invention ainsi que des caractéristiques additionnelles liées aux modes de réalisation considérés. Par souci de clarté les mêmes éléments porteront les mêmes repères dans les différentes figures.

L'invention sera mieux comprise et d'autres caractéristiques, buts et avantages de celle-ci apparaîtront au cours de la description détaillée qui va suivre et en regard des dessins annexés donnés à titre d'exemples non limitatifs et sur lesquels :
La figure 1, déjà citée illustre un dispositif acoustique à onde de surface SAW selon l'état de la technique.
La figure 2 déjà citée illustre un agencement de SAW élémentaires dans une configuration de filtre à échelle « ladder » selon l'état de la technique.
La figure 3A illustre le principe d'une première variante du dispositif à onde acoustique de surface selon l'invention.
La figure 3B illustre un premier mode de réalisation du dispositif selon l'invention dans lequel des électrodes sont reliées individuellement au circuit de commutation de sorte que la modification de connexion des électrodes s'opère individuellement.
La figure 3C illustre un deuxième mode de réalisation du dispositif selon l'invention dans lequel des électrodes sont reliées entre elles pour former des paquets, chaque paquet étant relié au circuit de commutation de sorte que la modification de connexion des électrodes s'opère par paquet.
La figure 4 illustre les courbes de dispersion caractéristiques des miroirs pour deux configurations différentes de conditions aux limites électriques imposées sur chacune des électrodes de ces miroirs.
La figure 5 illustre l'évolution des bandes interdites pour les deux cas 100% à la masse et 100% flottant en fonction du paramètre a/p des électrodes des miroirs.
La figure 6 illustre les variations en fonction de la fréquence du module du coefficient de réflexion acoustique simulé des miroirs pour les deux conditions aux limites électriques appliquées sur les électrodes de ces miroirs.
La figure 7 présente les variations en fonction de la fréquence du paramètre S11 électrique du résonateur lorsque les conditions sur les miroirs sont modifiées selon quatre configurations différentes.

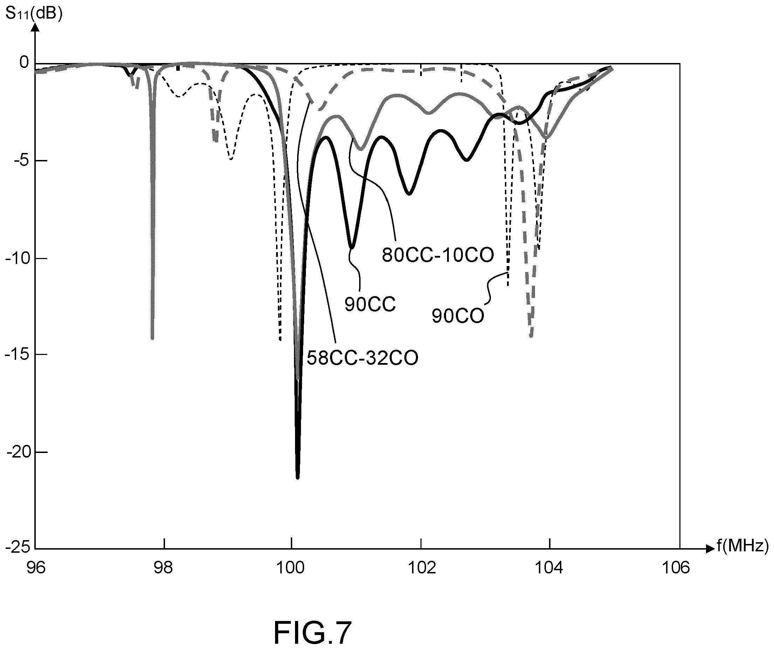

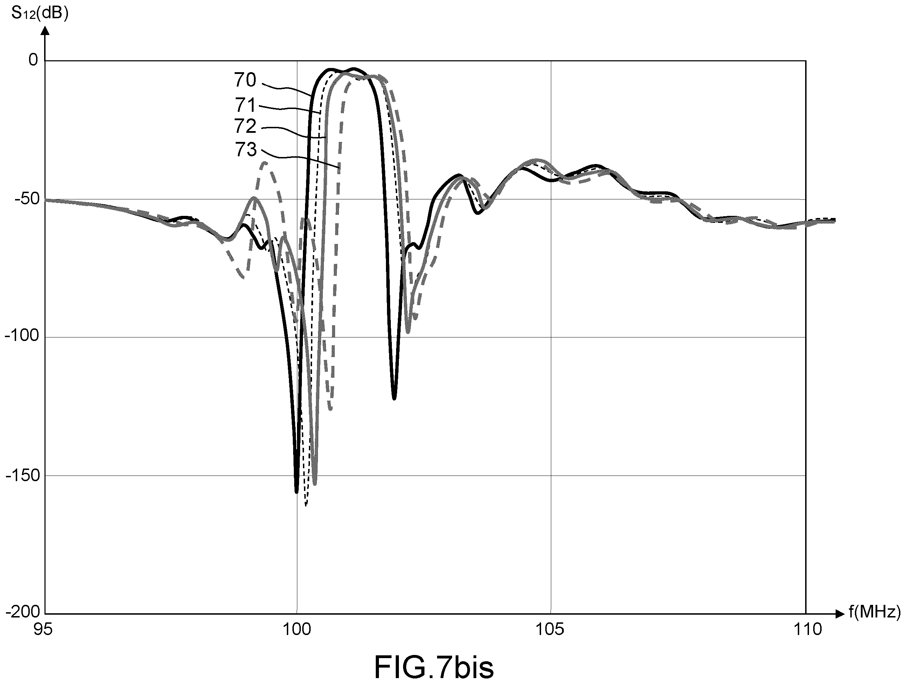

La figure 7bis illustre le coefficient S12 électrique en fonction de la fréquence f d'un filtre complexe dans une configuration « ladder » avec 3 dispositifs selon l'invention, pour 4 configurations de connexion des électrodes des miroirs.

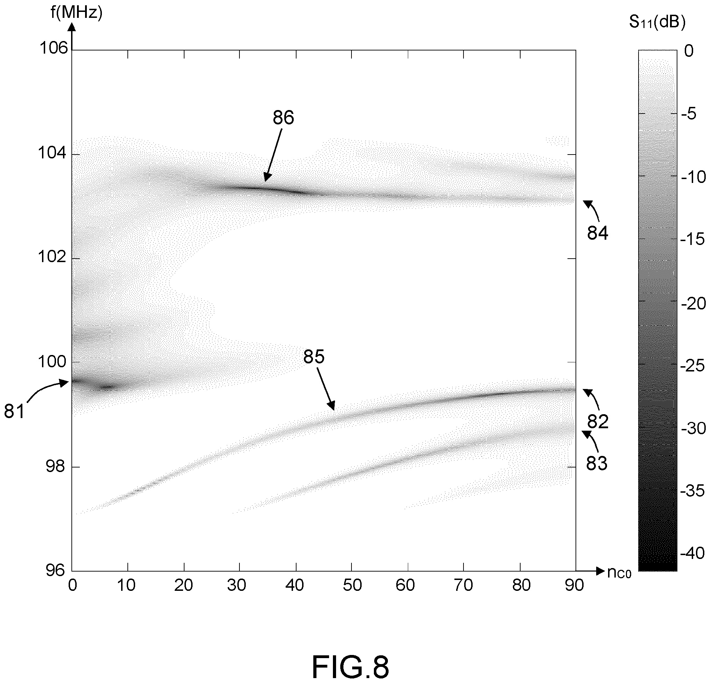

La figure 8 présente en niveaux de gris les variations du paramètre S11 du résonateur simple port en fonction d'une part du nombre n_{CO} des électrodes en condition flottante (de 0 à 90) et d'autre part en fonction de la fréquence.

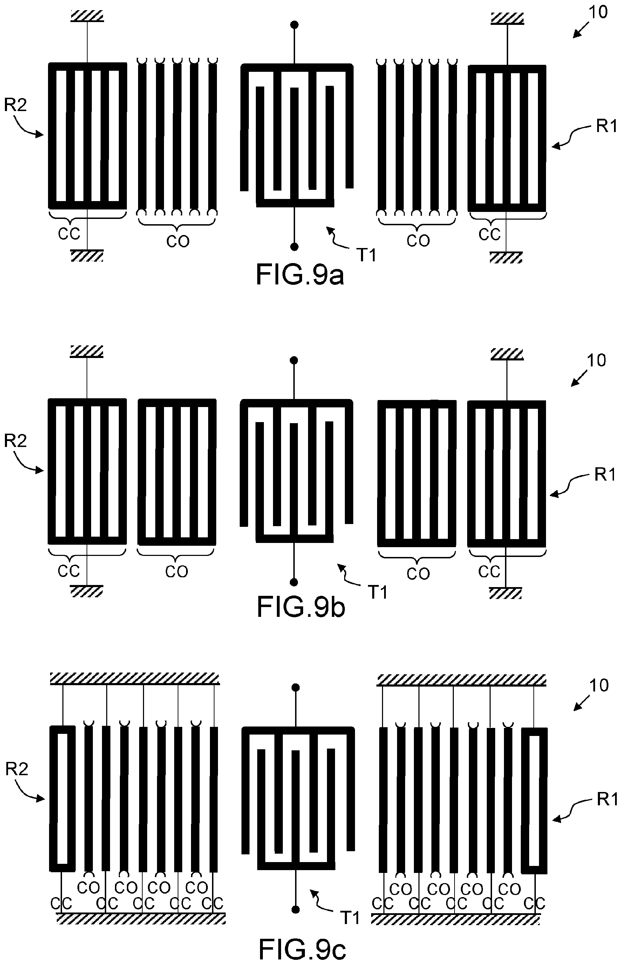

Les figures 9a, 9b et 9c illustrent un mode de réalisation de l'invention dans lequel, pour chaque réseau, des électrodes sont reliées entre elles définissant des paquets, la connexion s'effectuant par paquet. Les figures 9a, 9b et 9c illustrent également différents agencements des deux types de connexion CC et CO qui peuvent être combinés ensemble. Sur les figures 9a et 9b, pour chaque réseau, un sous ensemble d'électrodes voisines disposées à l'extrémité du réseau opposée au transducteur est connecté à la masse. Sur la figure 9c pour chaque réseau, une pluralité d'électrodes successives présente une alternance de connexion à la masse CC et flottante CO.

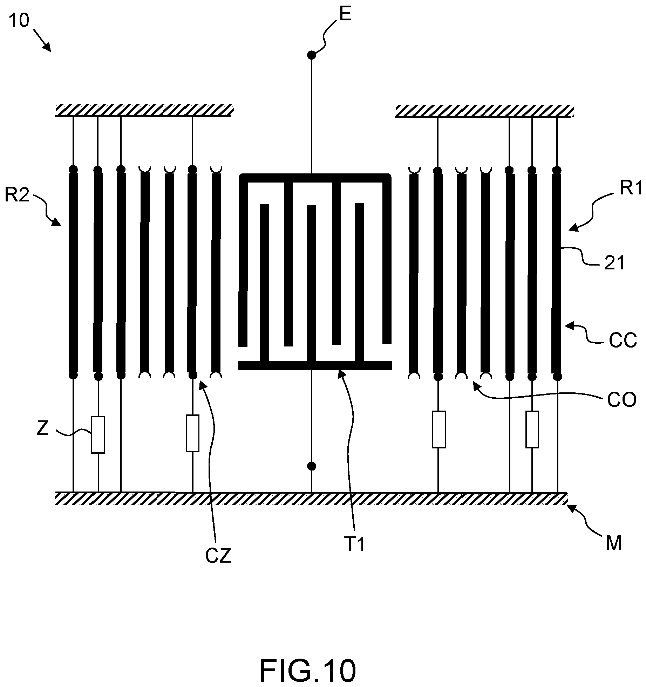

La figure 10 illustre une deuxième variante du dispositif selon l'invention dans laquelle, pour au moins un sous ensemble des électrodes de chaque miroir, une impédance Z est introduite entre chacune des électrodes du sous ensemble et la masse, définissant un troisième type de connexion CZ.

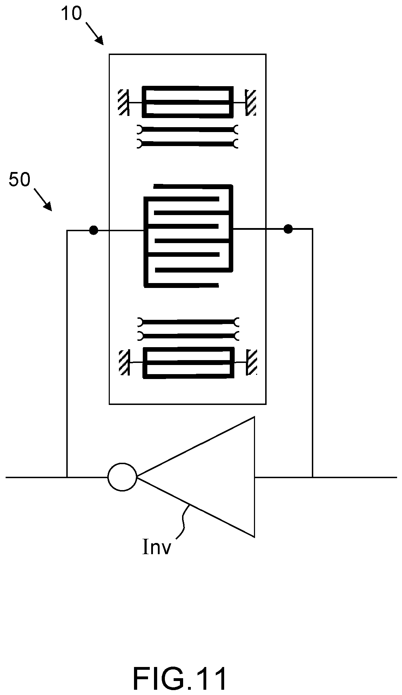

La figure 11 illustre un oscillateur stabilisé en fréquence par un dispositif selon l'invention.

### DESCRIPTION DETAILLEE DE L'INVENTION

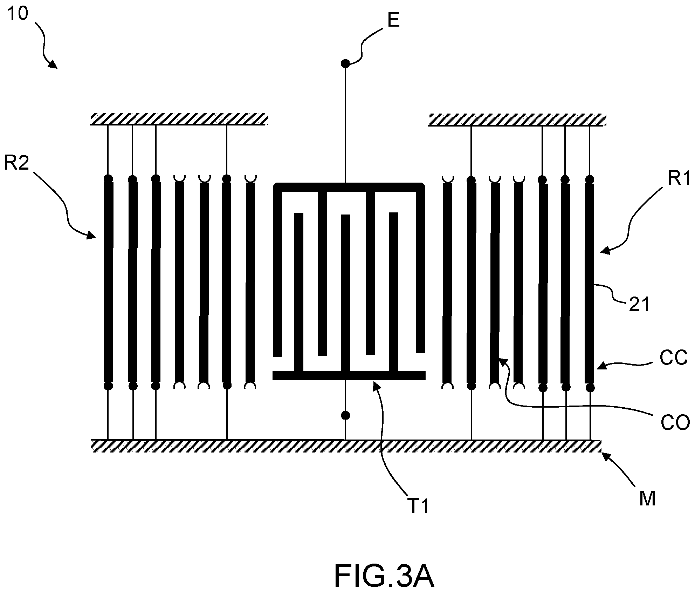

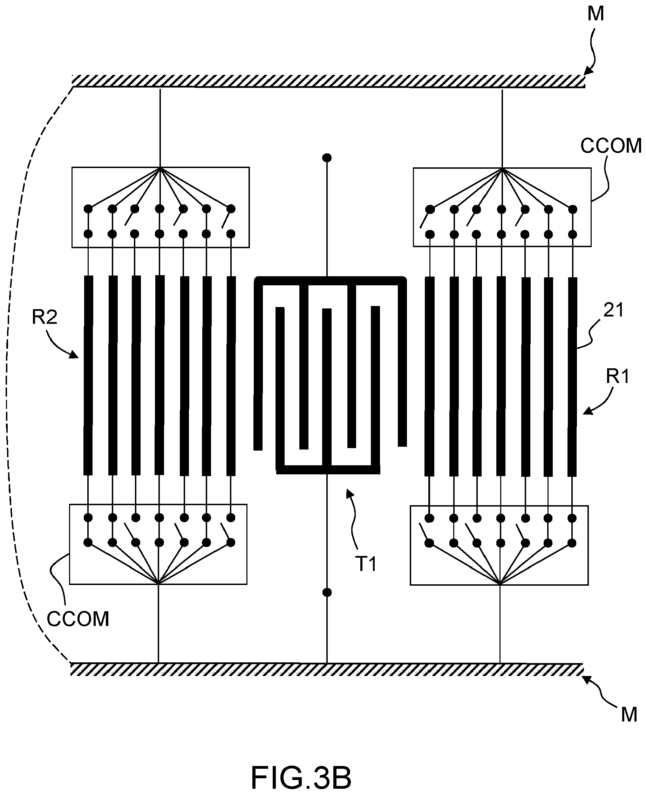

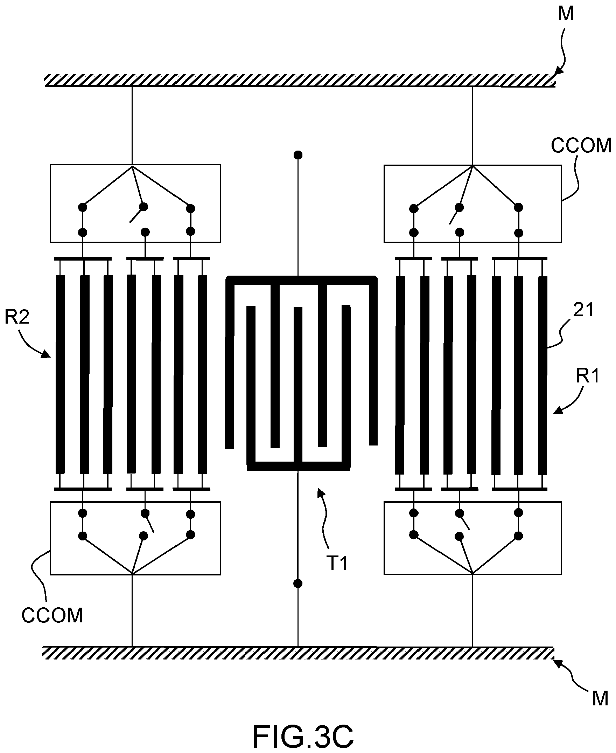

Le principe du dispositif à onde acoustique de surface 10 selon l'invention est illustré figure 3. Le dispositif présente une structure proche de celle d'un SAW selon l'état de la technique, mais dans lequel on a modifié les conditions aux limites électriques des miroirs.

Le dispositif 10 comprend au moins un transducteur. Il en comprend préférentiellement un (SAW simple port) ou deux (SAW double port). La figure 1 non limitative illustre un SAW selon l'invention double port avec deux transducteurs T1 et T2. Le dispositif 10 comprend également deux réflecteurs acoustiques disposés de part et d'autre de l'au moins un transducteur de manière à former une cavité, chaque réflecteur acoustique comprenant un réseau d'électrodes R1, R2 en forme de lignes 21 parallèles entre elles.

Chaque réseau d'électrodes comprend un sous ensemble d'électrodes connectées à un potentiel de référence dénommé masse M définissant un premier type de connexion CC (pour Court Circuit), et un sous ensemble d'électrodes qui ne sont connectées à aucun potentiel, c'est-à-dire qui présentent une connexion flottante définissant un deuxième type de connexion CO (pour Circuit Ouvert), tel qu'illustré figure 3. Les connexions en circuit ouvert (flottantes) sont symbolisées par les arcs de cercle aux extrémités des électrodes. Ainsi contrairement au SAW de l'état de la technique, certaines électrodes du dispositif selon l'invention présentent une connexion de type flottant.

La figure 3 illustre une première variante de l'invention selon laquelle chaque électrode ne peut présenter que le premier (CC) ou le deuxième (CO) type de connexion.

Le dispositif 10 selon l'invention comprend en outre au moins un circuit de commutation CCOM configuré pour modifier la répartition des connexions d'au moins une partie des électrodes de chaque réseau entre les différents types de connexion. La reconfiguration possible des connexions en dynamique confère au dispositif selon l'invention de l'agilité en fréquence. Ainsi la maîtrise électrique de l'agilité en fréquence est obtenue grâce à la modification des conditions aux limites électriques dans les miroirs. Le concept de l'invention considère la modification des conditions aux limites électriques pour chaque électrode élémentaire des miroirs. L'ensemble de ces modifications correspond à une fonction de répartition à l'intérieur du miroir, fixée a priori ou modifiable dynamiquement grâce à un circuit de commutation. Cette fonction de répartition permet de contrôler la bande de fréquences interdites des miroirs et ainsi de modifier les conditions de résonance des ondes stationnaires à l'intérieur de la cavité.

L'agilité en fréquence contrôlée assure l'intégrité des figures de mérite du filtre transposées à chaque nouvelle fréquence nominale déterminée par le phénomène d'agilité en fréquence.

Selon un premier mode de réalisation illustré figure 3B des électrodes sont reliées individuellement au circuit de commutation de sorte que la modification de connexion des électrodes s'opère individuellement.

Selon un deuxième mode de réalisation illustré figure 3C des électrodes sont reliées entre elles pour former des paquets, chaque paquet étant relié au circuit de commutation de sorte que la modification de connexion des électrodes s'opère par paquet.

Dans la suite pour plus de clarté le comportement fréquentiel du dispositif est explicité sans la présence de circuit(s) de commutation(s). Pour chaque réseau, ce ou ces circuits peuvent connecter l'ensemble des électrodes ou seulement une partie d'entre elles, les autres étant connectées directement à la masse ou en l'air et n'étant donc pas reconfigurables.

Pour mieux comprendre l'incidence de cette modification des conditions de connexion des électrodes des miroirs sur le comportement d'un SAW les inventeurs ont introduit le concept de bande interdite électrique que nous allons décrire à présent.

Dans une structure périodique infinie, les courbes de dispersion présentent les variations des fréquences des ondes acoustiques qui se propagent dans la structure en fonction du nombre d'onde k, pour une direction de propagation donnée. Ces courbes permettent d'identifier des bandes passantes, bandes de fréquences dans lesquelles les ondes se propagent et sont caractérisées par un nombre d'onde réel k, et, sous certaines conditions, des bandes interdites, bandes de fréquences dans lesquelles les ondes sont évanescentes et sont caractérisées par un nombre d'onde complexe k. Dans ces bandes de fréquences il n'existe pas de mode propagatif dans le miroir, et le coefficient de réflexion des ondes acoustiques de surface incidentes sur ce miroir peut donc prendre des valeurs proches de l'unité (réflexion totale). Ainsi, dans ces bandes de fréquences, les miroirs constituent en général de bons réflecteurs acoustiques.

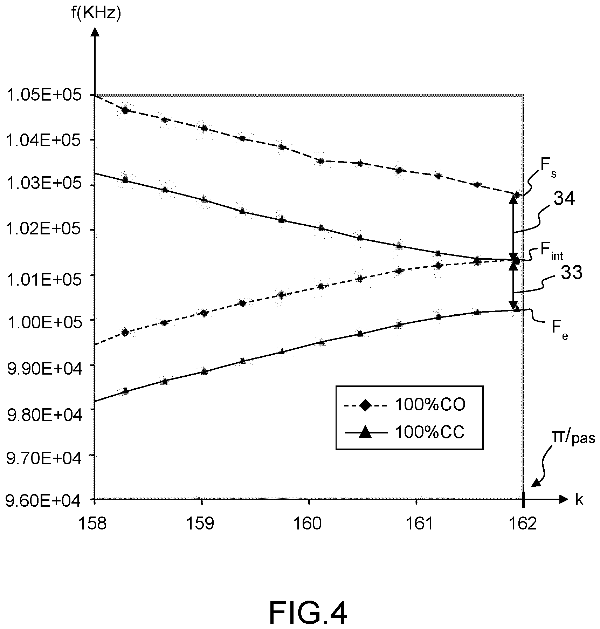

Les inventeurs ont montré que la modification des connexions des électrodes des miroirs avait une incidence sur la bande interdite. La figure 4 illustre les courbes de dispersion caractéristiques sur la zone de Brillouin jusqu'à π/p (avec p la période spatiale du réseau d'électrodes) pour les ondes de surface dans les miroirs, pour deux configurations différentes de conditions aux limites électriques imposées sur chacune des électrodes.

La figure 4 a été calculée pour l'exemple d'un substrat LiNbO₃(YXI)/128, comportant à sa surface un réseau d'électrodes en aluminium d'épaisseur h = 400 nm, de largeur a = 6.8 µm et de période p = 19.4 µm (a/p = 0.35). La direction de propagation est perpendiculaire à la longueur des électrodes.

Le trait plein correspond à toutes les électrodes des miroirs connectées en court-circuit (100% CC), c'est-à-dire reliées à la masse. On note à π/p une bande interdite 33 [Fe ; Fint]. Cette bande interdite 33 est étroite car le cristal phononique peut être considéré comme un matériau quasi-homogène avec un potentiel nul en surface.

Le trait pointillé correspond à toutes les électrodes des miroirs laissées flottantes (100% CO). On note à π/p une bande interdite 34 [Fint ; Fs] plus importante de borne supérieure Fs.

Ces deux bandes interdites 33 et 34 (mise à la masse ou condition flottante) sont liées à la même géométrie et aux mêmes matériaux. Elles ne se différencient que par les conditions aux limites électriques imposées. C'est pourquoi, elles sont appelées Bandes interdites électriques (BIE).

Les largeurs relatives des bandes interdites électriques sont liées au coefficient de couplage électromécanique associé à l'onde de surface se propageant dans le substrat piézoélectrique de la structure SAW.

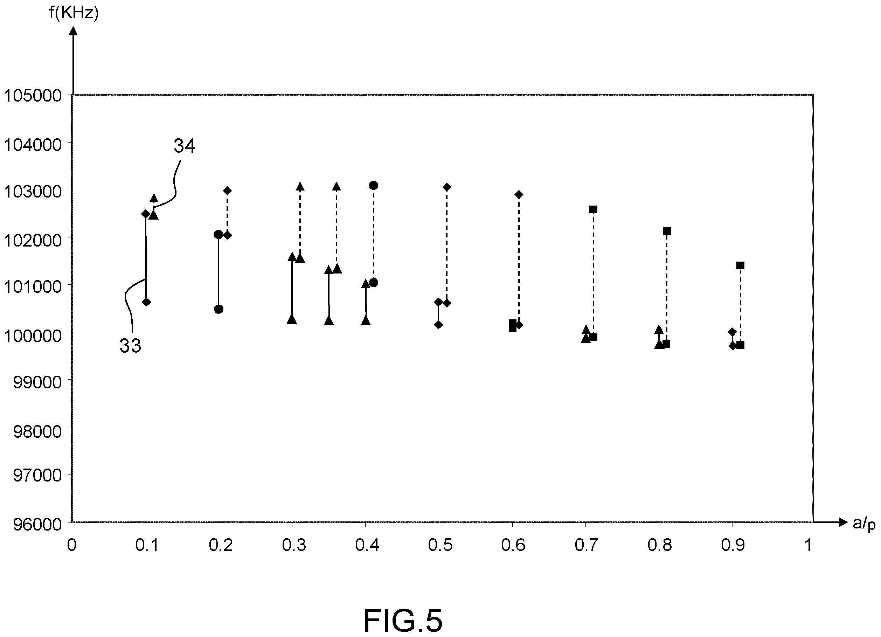

La figure 5 illustre l'évolution des bandes interdites 33 (100% CC) et 34 (100%CO) en fonction du paramètre a/p (cas de référence : exemple précédent). On constate qu'en fonction du rapport a/p entre la taille de l'électrode a et la périodicité p, plusieurs situations peuvent exister en fonction de la connexion électrique sur les électrodes (mise à la masse ou condition flottante) : bandes interdites qui se superposent, qui se décalent, qui s'élargissent, ou qui se réduisent

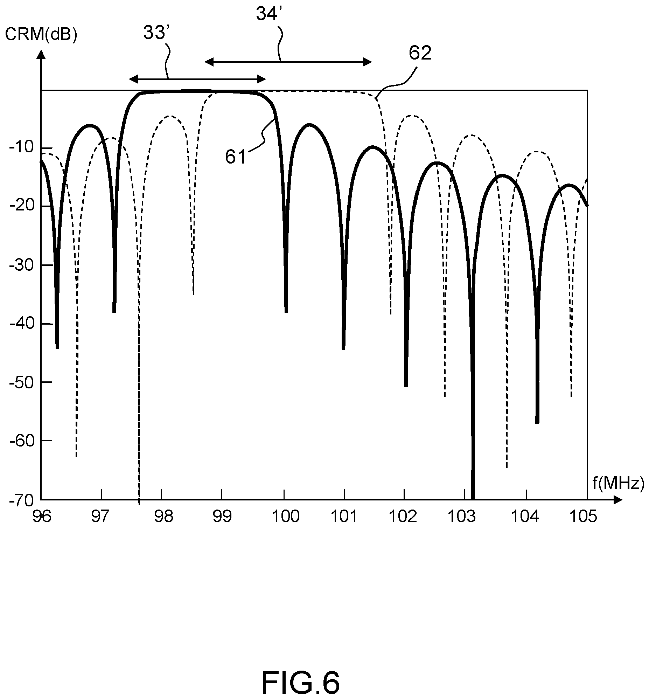

La modification des bandes interdites avec la condition électrique imposée entraîne un changement du coefficient de réflexion pour les ondes de surface incidentes sur les miroirs. La figure 6 illustre les variations en fonction de la fréquence du module CRM du coefficient de réflexion simulé des miroirs lorsque la condition aux limites électrique appliquée sur les électrodes est mise à la masse (100% CC) courbe 61, ou en condition flottante (100% CO) courbe 62 pour une épaisseur h d'électrode de 200 nm, une période p de 19.4 µm, une largeur a = 6.8 µm, et un matériau substrat en LiNbO3, coupe(YXI)/128.

On note que les bandes de fréquences 33' et 34' dans lesquelles la réflexion est égale à 1 (0dB) sont proches des bandes interdites présentées à la figure 4, un peu décalées du fait du changement de l'épaisseur des électrodes. Les deux bandes de réflexion sont décalées et jointives. Ainsi les bandes de réflexion acoustique des miroirs peuvent être contrôlées électriquement.

Cette modification du coefficient de réflexion des miroirs a une incidence directe sur le comportement fréquentiel d'un SAW réalisé avec les miroirs. Considérons maintenant un résonateur simple port comportant un transducteur T1 et les deux miroirs de Bragg précédemment étudiés de part et d'autre (voir figure 3). Chacun des miroirs comporte un réseau de 90 électrodes et ont un a/p de 0.35, le transducteur central comporte 48 électrodes avec un a/p de 0.45. L'énergie électrique réfléchie par le résonateur est associée au carré du paramètre S11. La figure 7 présente les variations du paramètre S11 du résonateur en fonction de la fréquence, lorsque les conditions sur les miroirs sont modifiées selon quatre configurations :
- 90 électrodes CC (à la masse)
- 90 électrodes CO (flottantes)
- 58 électrodes CC - 32 électrodes CO
- 80 électrodes CC - 10 électrodes CO

Dans les deux dernières configurations les 32 OU 10 électrodes mises en conditions flottantes sont celles proches du transducteur T1.

Les minima du paramètre S11 correspondent à des résonances élastiques de l'ensemble transducteur + miroirs pour lesquelles une quantité plus importante de l'énergie électrique incidente est transformée en énergie mécanique.

Lorsque toutes les électrodes des miroirs sont à la masse, on note une résonance principale à 100 MHz.

Lorsque toutes les électrodes des miroirs sont en condition flottante, cette résonance est peu modifiée par le changement des conditions aux limites électriques, mais on voit apparaître davantage de résonances à fort coefficient de qualité. La courbe avec toutes les électrodes en condition flottante pour les miroirs met en évidence le caractère multimodal du résonateur simple port.

Les deux autres courbes correspondent à deux situations intermédiaires avec les électrodes des miroirs proches du transducteur mises petit à petit en condition flottante.

On voit la potentialité du dispositif selon l'invention, qui peut avoir, pour des paramètres géométriques identiques, un comportement fréquentiel différencié grâce à la configuration de connexion des électrodes des miroirs. Préférentiellement la répartition des connexions des électrodes entre les différents types de connexions est symétrique par rapport au(x) transducteur(s). Cela facilite les simulations et rend la sélection en fréquence acoustique plus précise.

Préférentiellement la connexion à la masse est réalisée aux deux extrémités de chaque électrode 21. Cela permet de connecter le plan de masse supérieur au plan de masse inférieur, assurant ainsi la continuité de la masse.

Grâce au dispositif selon l'invention, on modifie les conditions aux limites électriques des miroirs afin de modifier la fréquence de fonctionnement du résonateur, sans changer les caractéristiques du dispositif (matériau substrat, paramètres géométriques...) et en préservant l'intégrité de la fonction filtrage.

Le fonctionnement standard du dispositif 10 de l'invention dans la configuration à deux ports est directement de type filtre. Le concept de l'invention peut également être élargi aux filtres SAW dits en cascades. Dans ce cas, on réalise un filtre à l'aide d'une pluralité de dispositifs 10 à onde acoustique de surface selon l'invention à un seul port, associés électriquement selon un agencement en série et/ou en parallèle. De manière connue la combinaison de différents SAW permet de réaliser un filtre conforme à une spécification déterminée, en maîtrisant la forme de la bande du filtre (que l'on souhaite préférentiellement à flancs abrupts), sa largueur, sa fréquence nominale...

La figure 7bis illustre les performances d'un filtre complexe dans une configuration « ladder » telle qu'illustrée figure 2 mais dans laquelle on a remplacé les SAW selon l'état de la technique par des SAW selon l'invention. Les deux dispositifs en parallèle (équivalent de 20(1) et 20(2)) sont identiques, simple port, et réalisés à partir du même transducteur T1 aux caractéristique suivantes :
T1 : 18 paires d'électrodes, p=19.1 µm, a/p = 0.3, h=0.17 µm

Les électrodes du réseau de chaque miroir sont au nombre de 60, avec p=19 µm, a/p = 0.4, h=0.17 µm.

Le dispositif en série (équivalent de 20(3)) est également simple port et réalisé à partir du transducteur T1' aux caractéristiques suivantes :
T1' : 11 paires d'électrodes, p=18.5 µm, a/p = 0.5, h=0.17 µm

Les électrodes du réseau de chaque miroir sont au nombre de 60, avec p=19.2 µm, a/p = 0.4, h=0.17 µm.

Les quatre courbes 70 à 73 illustrent la transmission théorique du filtre « ladder » via son paramètre S₁₂ en fonction de la fréquence f pour différentes configurations de connexion des électrodes des miroirs.

La courbe 70 correspond pour les trois dispositifs aux 60 électrodes à la masse.

La courbe 71 correspond pour les trois dispositifs à 55 électrodes à la masse (CC) et les 5 électrodes les plus proches du transducteur en circuit ouvert (CO).

La courbe 72 correspond pour les trois dispositifs à 50 électrodes en CC et les 10 électrodes les plus proches du transducteur en CO.

La courbe 73 correspond pour les trois dispositifs à 40 électrodes en CC et les 20 électrodes les plus proches du transducteur en CO.

On constate que l'on a bien réalisé un filtre passe bande, les différentes configurations de connexion résultant en un décalage de la fréquence nominale du filtre d'environ 1 MHz sans dégradation des autres figures de mérite du filtre.

En outre la réalisation d'un filtre complexe à partir d'un même filtre élémentaire 10 selon l'invention (mêmes paramètres géométriques) facilite la fabrication.

Il devient également possible d'effectuer post-fabrication des ajustements de spécification, en venant localement modifier le type de connexion d'électrodes choisies.

La figure 8 présente en niveaux de gris les variations du paramètre S11 du résonateur simple port en fonction de la fréquence et du nombre n_{CO} des électrodes en condition flottante (de 0 à 90).

Les zones en foncé correspondent à des résonances. Cette figure est riche en informations :
- lorsque toutes les électrodes des miroirs sont à la masse (n_{CO} = 0), on trouve une résonance à 100 MHz, voir 81.
- lorsque toutes les électrodes des miroirs sont en condition flottante (n_{CO} = 90), on retrouve une résonance vers 99.8 MHz (voir 82), ainsi que d'autres résonances plus basses (vers 99 MHz- voir 83) et plus hautes (vers 103 MHz- voir 84), mettant en évidence le caractère multimodal du dispositif
- lorsque peu d'électrodes sont en condition flottante (n_{CO} <10), on observe une variation faible de la résonance (de quelques kHz autour de la fréquence centrale à 100 MHz). C'est une agilité continue mais faible de la résonance principale (voir 81).

- à partir de 5-10 électrodes et jusqu'à 90 électrodes en condition flottante, on observe une résonance qui évolue de façon continue de 97.3 MHz à 99.8 MHz (voir 85). La variation relative est de 2.5 %, c'est une agilité continue d'une résonance secondaire sur une large bande. Cette résonance secondaire représente la fréquence d'entrée de bande interdite du dispositif : tout au long du changement de nombre d'électrodes en potentiel flottant.
- lorsqu'environ 30 à 40 électrodes sont en condition flottante, on observe une résonance prononcée vers 103.5 MHz (voir 86). La mise en condition flottante de ces électrodes peut être vue comme un saut de la fréquence principale du résonateur. On réalise ici une fonction de commutation en fréquence.

Selon un mode de réalisation, pour chaque réseau, les connexions des électrodes sont réalisées individuellement, comme illustré figure 3. Selon un premier exemple les connexions individuelles s'effectuent pour la totalité des électrodes via un circuit de commutation, comme illustré figure 3B, et selon un deuxième exemple les connexions individuelles s'effectuent pour partie seulement via un circuit de commutation.

Selon un autre mode de réalisation illustré figure 3C et figures 9a, 9b et 9c, pour chaque réseau, des électrodes sont reliées entre elles définissant des paquets, la connexion s'effectuant par paquet. La figure 9a illustre une connexion par paquet des électrodes à la masse, et la figure 9b illustre des électrodes flottantes également reliées entre elles. Les inventeurs ont montré que ces paquets d'électrodes flottantes ont également un effet tel que décrit plus haut, mais légèrement différent. Selon un premier exemple les connexions par paquet des électrodes s'effectuent pour la totalité des électrodes via un circuit de commutation, comme illustré figure 3C, et selon un deuxième exemple les connexions par paquet s'effectuent pour partie seulement via un circuit de commutation.Les deux modes de réalisation peuvent bien entendu être combinés, certaines connexions s'opérant par paquets et d'autres individuellement, par l'intermédiaire d'un circuit de commutation ou pas.

Les figures 9a, 9b et 9c illustrent également différents exemples d'agencement des deux types de connexions qui peuvent être combinés ensemble.

Sur les figures 9a et 9b, pour chaque réseau, un sous ensemble d'électrodes voisines disposées à une extrémité du réseau (ici celle opposée au transducteur) est connecté à la masse.

Egalement sur les figures 9a et 9b, pour chaque réseau, un sous ensemble d'électrodes voisines disposées à une extrémité du réseau (ici celle du côté transducteur) présente une connexion flottante.

Sur la figure 9c, pour chaque réseau, on a un bloc « homogène » de deux CC (extrémité côté opposé au transducteur) et plusieurs électrodes successives présentant une alternance de connexions à la masse CC et flottantes CO. La figure 9c illustre un réseau incluant un motif périodique de connexions d'électrodes de type 1 CC/1 CO, mais bien entendu d'autres types de motifs périodiques sont possibles, tels que 1 CC/2 CO ou 1 CC/3 CO. Ainsi selon ce mode de réalisation pour chaque réseau des électrodes forment un motif périodique, un motif comprenant au moins une électrode connectée à la masse et une électrode flottante.

L'utilisation d'un motif périodique à plusieurs connexions permet également d'ouvrir des bandes interdites électriques à des fréquences fractionnaires nF/N, où F est la fréquence de fonctionnement initiale du résonateur, N le nombre d'électrodes dans un motif, et n un entier. Ainsi, à titre d'exemple, dans le cas de la période double, si une électrode sur deux est à la masse et une électrode sur deux est en condition flottante, la bande interdite électrique à la fréquence de fonctionnement du résonateur subsiste et des bandes interdites électriques supplémentaires apparaissent à la fréquence moitié avec la même largeur relative et à 1,5 fois la fréquence. Ces observations se généralisent pour des périodes triples, quadruples etc. Il est donc possible par simple modification des conditions aux limites électriques des miroirs d'obtenir des fréquences de fonctionnement fractionnaires.

De manière générale les connexions électriques par groupe ou basées sur un motif périodique permettent d'augmenter les possibilités offertes par le dispositif selon l'invention.

Selon une deuxième variante du dispositif 10 selon l'invention illustrée figure 10, pour au moins un sous ensemble des électrodes de chaque miroir, une impédance Z est introduite entre chacune desdites électrodes du sous ensemble et la masse, définissant un troisième type de connexion CZ. Ce troisième type de connexion permet encore d'élargir les possibilités de design du filtre par engineering de la bande interdite électrique, en introduisant tout un ensemble de cas intermédiaires entre les conditions CO (équivalente à une impédance infinie entre l'électrode et la masse) et CC (équivalente à une impédance nulle entre ces deux mêmes points). L'essentiel de ce qui a été décrit précédemment reste vrai avec trois types de connexion. L'impédance Z peut par ailleurs être de type classique R, L ou C ou plus complexe, telle une capacité négative. Ce peut être un circuit passif ou actif (capacité externes : positives ou négative, selfs variables). Ce troisième type de connexion peut être implémenté avec une connexion à la masse réalisée de manière directe ou réalisée par l'intermédiaire d'un circuit de commutation.

Le ou les circuits de commutation du dispositif 10 selon l'invention réalisent une reconfiguration dynamique de la répartition des types de connexions des électrodes des miroirs, ce qui permet une modification, éventuellement temps réel, des caractéristiques fréquentielles du filtre comme sa fréquence nominales. En reprenant l'enseignement de la figure 8, on constate qu'en fonction des différentes configurations de connexion d'électrodes choisies, le dispositif selon l'invention offre plusieurs types d'agilité :
(1) une agilité continue mais faible de la fréquence de fonctionnement (quelque pour mille de la fréquence de fonctionnement),
(2) une agilité continue et notable de la fréquence de fonctionnement (quelques pourcents de la fréquence de fonctionnement),
(3) un saut de la fréquence de fonctionnement (quelques pourcents de la fréquence de fonctionnement),
(4) l'utilisation du dispositif à des fréquences de fonctionnement fractionnaires si le transducteur du dispositif est large bande.

La vitesse de travail du (des) circuit(s) CCOM est soit lente, par exemple pour réaliser un ajustement du filtre après une mesure de température, soit rapide (une à quelques commutations par microseconde) par exemple pour des applications télécom ou militaires.

Les circuits CCOM sont par exemple des micro-switchs fondés sur les microéléments électromécaniques dans le domaine RF (RF-MEMs).

Le couplage des RF-MEMS et des SAW rend possible le contrôle du type de connexion de chaque électrode. D'autres systèmes de commutation par exemple à base de transistors FET, de diodes, de MOS faible capacité sont possibles. Des commutateurs à base de circuits électroniques permettent de s'affranchir de la dualité mise à la masse/condition flottante en réalisant les connexions de type CZ.

L'agilité en fréquence permet en outre une réduction de l'encombrement volumique des dispositifs de filtrage et de réduire la consommation d'énergie.

Selon un autre mode de fonctionnement le dispositif selon l'invention permet de réaliser un oscillateur. Ainsi selon un autre aspect l'invention concerne un oscillateur 50 tel qu'illustré figure 11 comprenant un circuit inverseur Inv et un dispositif 10 à onde acoustique de surface selon l'invention agencé en parallèle dudit circuit inverseur. Pour cette application le dispositif 10 doit avoir deux transducteurs définissant une entrée et une sortie. L'oscillateur ainsi réalisé va osciller sur la fréquence définie par le dispositif à onde de surface.

## Revendications

1. Dispositif (10) à onde acoustique de surface agile en fréquence comprenant :
- au moins un transducteur (T1, T2),
- deux réflecteurs acoustiques (M1, M2) disposés de part et d'autre de l'au moins un transducteur de manière à former une cavité, chaque réflecteur acoustique comprenant un réseau d'électrodes (R1, R2) en forme de lignes (21) parallèles entre elles, chaque réseau comprenant un sous ensemble d'électrodes connectées à un potentiel de référence dénommé masse (M) définissant un premier type de connexion (CC), et un sous ensemble d'électrodes qui ne sont connectées à aucun potentiel, c'est-à-dire qui présentent une connexion flottante définissant un deuxième type de connexion (CO),
- au moins un circuit de commutation (CCOM) configuré pour modifier la répartition des connexions d'au moins une partie des électrodes de chaque réseau entre les différents types de connexion.

2. Dispositif (10) à onde acoustique de surface selon la revendication 1 comprenant un ou deux transducteurs.

3. Dispositif (10) à onde acoustique de surface selon l'une des revendications 1 ou 2 dans lequel chaque électrode ne peut présenter que le premier (CC) ou le deuxième (CO) type de connexion.

4. Dispositif (10) à onde acoustique de surface selon l'une des revendications 1 ou 2 comprenant en outre, pour au moins un sous ensemble des électrodes de chaque réflecteur acoustique, une impédance (Z) entre chacune desdites électrodes dudit sous ensemble et la masse, définissant un troisième type de connexion (CZ).

5. Dispositif (10) à onde acoustique de surface selon l'une des revendications précédentes dans lequel la répartition des connexions des électrodes entre les différents types est symétrique par rapport à l'au moins un transducteur.

6. Dispositif à onde acoustique de surface selon l'une des revendications précédentes dans lequel, pour chaque réseau, des connexions des électrodes sont réalisées individuellement.

7. Dispositif à onde acoustique de surface selon l'une des revendications précédentes dans lequel, pour chaque réseau, des électrodes sont reliées entre elles définissant des paquets, la connexion s'effectuant par paquet.

8. Dispositif (10) à onde acoustique de surface selon l'une des revendications précédentes dans lequel, pour chaque réseau, un sous ensemble d'électrodes voisines disposées à une extrémité du réseau est connecté à la masse.

9. Dispositif (10) à onde acoustique de surface selon l'une des revendications précédentes dans lequel, pour chaque réseau, un sous ensemble d'électrodes voisines disposées à une extrémité du réseau présente une connexion flottante.

10. Dispositif (10) à onde acoustique de surface selon l'une des revendications précédentes dans lequel, pour chaque réseau, des électrodes forment un motif périodique, un motif comprenant au moins une électrode connectée à la masse et une électrode flottante.

11. Dispositif à onde acoustique de surface selon l'une des revendications précédentes dans lequel, pour chaque réseau, des électrodes sont reliées individuellement au circuit de commutation de sorte que la modification de connexion desdites électrodes s'opère individuellement.

12. Dispositif à onde acoustique de surface selon l'une des revendications 1 à 11 dans lequel, pour chaque réseau, des électrodes sont reliées entre elles pour former des paquets, chaque paquet étant relié au circuit de commutation de sorte que la modification de connexion des électrodes s'opère par paquet.

13. Filtre en fréquence comprenant un dispositif à onde acoustique de surface selon l'une des revendications 1 à 12.

14. Filtre en fréquence comprenant une pluralité de dispositifs à onde acoustique de surface selon l'une des revendications 1 à 12 agencés en série et/ou en parallèle.

15. Oscillateur (50) comprenant un circuit inverseur (Inv) et un dispositif à onde acoustique de surface (10) selon l'une des revendications 1 à 12 agencé en parallèle dudit circuit inverseur, le dispositif à onde acoustique de surface comprenant deux transducteurs.

## Patentansprüche

1. Frequenzagile Oberflächenschallwellenvorrichtung (10), umfassend:
- mindestens einen Wandler (T1, T2),
- zwei Schallreflektoren (M1, M2), die auf beiden Seiten des mindestens einen Wandlers angeordnet sind, um einen Hohlraum zu bilden, wobei jeder Schallreflektor ein Netzwerk von Elektroden (R1, R2) in Form von zueinander parallelen Reihen (21) umfasst, wobei jedes Netzwerk eine Untermenge von Elektroden, die mit einem als Masse (M) bezeichneten Referenzpotential verbunden sind, das einen ersten Verbindungstyp (CC) definiert, und eine Untermenge von Elektroden, die nicht mit jeglichem Potential verbunden sind, d. h. die eine schwebende Verbindung aufweisen, die einen zweiten Verbindungstyp (CO) definiert, umfasst,
- mindestens eine Kommutationsschaltung (CCOM), die zum Modifizieren der Verteilung der Verbindungen von mindestens einem Teil der Elektroden von jedem Netzwerk zwischen den unterschiedlichen Verbindungstypen konfiguriert ist.

2. Oberflächenschallwellenvorrichtung (10) nach Anspruch 1, umfassend einen oder zwei Wandler.

3. Oberflächenschallwellenvorrichtung (10) nach einem der Ansprüche 1 oder 2, wobei jede Elektrode nur den ersten (CC) oder den zweiten (CO) Verbindungstyp aufweist.

4. Oberflächenschallwellenvorrichtung (10) nach einem der Ansprüche 1 oder 2, ferner umfassend für mindestens eine Untermenge der Elektroden von jedem Schallreflektor eine Impedanz (Z) zwischen jeder der Elektroden der Untermenge und der Masse, die einen dritten Verbindungstyp (CZ) definiert.

5. Oberflächenschallwellenvorrichtung (10) nach einem der vorhergehenden Ansprüche, wobei die Verteilung der Verbindungen der Elektroden zwischen den unterschiedlichen Typen in Bezug auf den mindestens einen Wandler symmetrisch ist.

6. Oberflächenschallwellenvorrichtung nach einem der vorhergehenden Ansprüche, wobei für jedes Netzwerk Verbindungen der Elektroden einzeln umgesetzt werden.

7. Oberflächenschallwellenvorrichtung nach einem der vorhergehenden Ansprüche, wobei für jedes Netzwerk Elektroden miteinander verbunden werden, wodurch Bündel definiert werden, wobei die Verbindung pro Bündel vorgenommen wird.

8. Oberflächenschallwellenvorrichtung (10) nach einem der vorhergehenden Ansprüche, wobei für jedes Netzwerk eine Untermenge von benachbarten Elektroden, die an einem Ende des Netzwerks angeordnet sind, mit der Masse verbunden ist.

9. Oberflächenschallwellenvorrichtung (10) nach einem der vorhergehenden Ansprüche, wobei für jedes Netzwerk eine Untermenge von benachbarten Elektroden, die an einem Ende des Netzwerks angeordnet sind, eine schwebende Verbindung aufweist.

10. Oberflächenschallwellenvorrichtung (10) nach einem der vorhergehenden Ansprüche, wobei für jedes Netzwerk Elektroden ein periodisches Muster bilden, wobei ein Muster mindestens eine Elektrode, die mit der Masse verbunden ist, und eine schwebende Elektrode umfasst.

11. Oberflächenschallwellenvorrichtung nach einem der vorhergehenden Ansprüche, wobei für jedes Netzwerk Elektroden einzeln mit der Kommutationsschaltung verbunden werden, so dass die Modifikation der Verbindung der Elektroden einzeln erfolgt.

12. Oberflächenschallwellenvorrichtung nach einem der Ansprüche 1 bis 11, wobei für jedes Netzwerk Elektroden miteinander verbunden werden, wodurch Bündel gebildet werden, wobei jedes Bündel mit der Kommutationsschaltung verbunden ist, so dass die Modifikation der Verbindung der Elektroden pro Bündel erfolgt.

13. Frequenzfilter, umfassend eine Oberflächenschallwellenvorrichtung nach einem der Ansprüche 1 bis 12.

14. Frequenzfilter, umfassend eine Vielzahl von Oberflächenschallwellenvorrichtungen nach einem der Ansprüche 1 bis 12, die seriell und/oder parallel eingerichtet sind.

15. Oszillator (50), umfassend eine Inverterschaltung (Inv) und eine Oberflächenschallwellenvorrichtung (10) nach einem der Ansprüche 1 bis 12, die parallel zu der Inverterschaltung eingerichtet ist, wobei die Oberflächenschallwellenvorrichtung zwei Wandler umfasst.

## Claims

1. A frequency-agile surface acoustic wave device (10) comprising:
- at least one transducer (T1, T2),
- two acoustic reflectors (M1, M2) disposed on either side of the at least one transducer so as to form a cavity, each acoustic reflector comprising an array of electrodes (R1, R2) in the form of rows (21) that are parallel to one another, each array comprising a subset of electrodes connected to a reference potential denoted ground (M) defining a first type of connection (CC), and a subset of electrodes which are not connected to any potential, that is to say which have a floating connection defining a second type of connection (CO),
- at least one switching circuit (CCOM) configured to modify the distribution of the connections of at least a part of the electrodes of each array between the different types of connection.

2. The surface acoustic wave device (10) according to claim 1, comprising one or two transducers.

3. The surface acoustic wave device (10) according to one of claims 1 or 2, wherein each electrode can have only the first (CC) or the second (CO) type of connection.

4. The surface acoustic wave device (10) according to one of claims 1 or 2, further comprising, for at least one subset of the electrodes of each acoustic reflector, an impedance (Z) between each of said electrodes of said subset and the ground, defining a third type of connection (CZ).

5. The surface acoustic wave device (10) according to one of the preceding claims, wherein the distribution of the connections of the electrodes between the different types is symmetrical with respect to the at least one transducer.

6. The surface acoustic wave device according to one of the preceding claims, wherein, for each array, connections of the electrodes are made individually.

7. The surface acoustic wave device according to one of the preceding claims, wherein, for each array, electrodes are linked to one another defining bunches, the connection being made per bunch.

8. The surface acoustic wave device (10) according to one of the preceding claims, wherein, for each array, a subset of neighboring electrodes disposed at one end of the array is connected to the ground.

9. The surface acoustic wave device (10) according to one of the preceding claims, wherein, for each array, a subset of neighboring electrodes disposed at one end of the array has a floating connection.

10. The surface acoustic wave device (10) according to one of the preceding claims, wherein, for each array, electrodes form a periodic pattern, a pattern comprising at least one electrode connected to the ground and a floating electrode.

11. The surface acoustic wave device according to one of the preceding claims, wherein, for each array, electrodes are linked individually to the switching circuit so that the modification of connection of said electrodes is applied individually.

12. The surface acoustic wave device according to one of claims 1 to 11, wherein, for each array, electrodes are linked to one another to form bunches, each bunch being linked to the switching circuit so that the modification of connection of the electrodes is applied per bunch.

13. A frequency filter comprising a surface acoustic wave device according to one of claims 1 to 12.

14. A frequency filter comprising a plurality of surface acoustic wave devices according to one of claims 1 to 12 arranged in series and/or in parallel.

15. An oscillator (50) comprising an inverting circuit (Inv) and a surface acoustic wave device (10) according to one of claims 1 to 12 arranged in parallel with said inverting circuit, the surface acoustic wave device comprising two transducers.
